# EUROPEAN PATENT APPLICATION

(11) **EP 4 199 055 A1**
(43) Date of publication of application: **21.06.2023**
(21) Application number: 22213510.5
(22) Date of filing: 14.12.2022
(51) Int. Cl.: H01L 21/768, H01L 23/31, H01L 23/522, H01L 23/528, H01L 23/532, H01L 23/00

(54) **METHOD OF MANUFACTURING A REDISTRIBUTION LAYER, REDISTRIBUTION LAYER, INTEGRATED CIRCUIT AND METHODS FOR ELECTRICALLY TESTING AND PROTECTING THE INTEGRATED CIRCUIT**

(30) Priority: 14.12.2021 IT 202100031340
(71) Applicant: STMicroelectronics S.r.l., 20864 Agrate Brianza (MB) (IT)
(72) Inventor: SCIARRILLO, Samuele, 20865 USMATE VELATE (MB) (IT); COLPANI, Paolo, 20864 AGRATE BRIANZA (MB) (IT)
(74) Representative: Studio Torta S.p.A.

(57) **Abstract**

A method of manufacturing a redistribution layer (32) for an integrated circuit (30), comprising the steps of: forming, on a conductive interconnection layer (33) of a wafer (60), a first insulating layer (37); forming a conductive body (40; 40, 38; 41) in electrical contact with said interconnection layer (33); covering the conductive body (40; 40, 38; 41) with an insulating region (42, 43) having an aperture (43a) that exposes a surface of the conductive body (40; 40, 38; 41); covering the surface of the conductive body (40; 40, 38; 41) and the insulating region (37, 43) with a protection layer (50) having a thickness lower than 100 nm and configured to provide a protection against oxidation and/or corrosion of said conductive body (40; 40, 38) .

## Description

The present invention relates to a method of manufacturing a redistribution layer, a redistribution layer, an integrated circuit including the redistribution layer, a method for performing an electrical test of the integrated circuit, and a method of manufacturing an encapsulation structure for an integrated circuit.

As is known, integrated circuits (ICs) are composed of several overlapping layers made of semiconducting, insulating and conductive materials, typically defined by photolithography.

In a first phase (front end of line, FEOL) of a manufacturing process of an integrated circuit, individual devices such as, among others, transistors, diodes, resistors and capacitors, are patterned on the surface of a wafer.

In a second phase (back end of line, BEOL), the individual devices are interconnected by conductive metal lines. In particular, due to the complexity of modern IC layouts and high density of individual devices, the back end of line process comprises manufacturing several stacked metal layers, electrically insulated from one another by dielectric layers; vias through the dielectric layers allow connecting any metal layer to the metal layers below and/or the one above.

In a third phase of the IC manufacturing process, belonging to the BEOL phase (which is of aid for the subsequent packaging processes), a redistribution layer (RDL) is patterned above the last metal interconnection layer. As is known, the redistribution layer is an extra metal layer used for routing the input/output pads to other locations on the die area, enabling simpler bonding (e.g. chip-to-chip bonding) during packaging manufacturing. Moreover it is a power metal layer able to reduce the I/O access resistance. As last metal layer is also designed to fit the packaging process requirements.

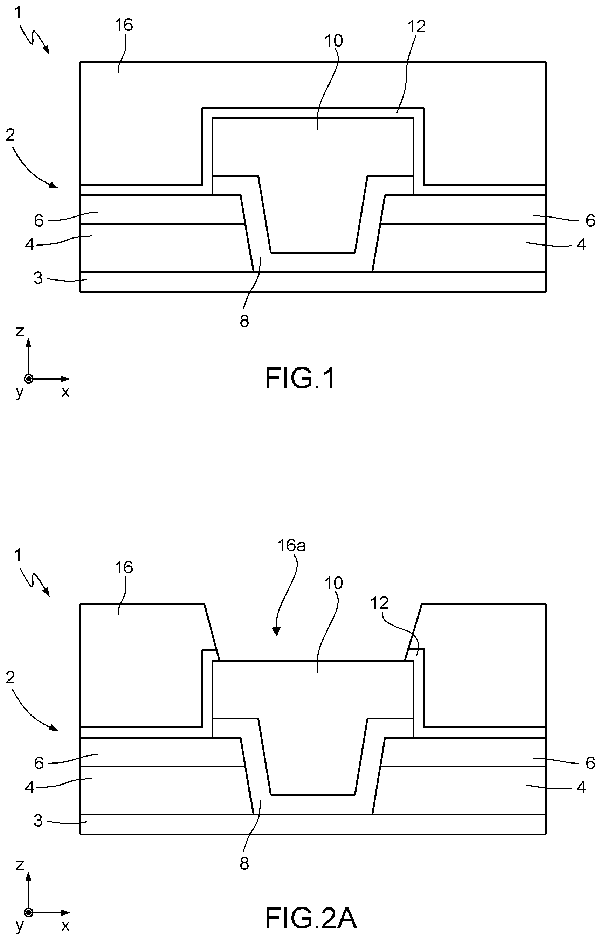

Figure 1 shows schematically a cross-section view of a portion of an IC 1 including a pad, which is not explicitly depicted and is the region of IC 1 to be accessed through wire bonding or other contact solutions during the packaging process, and a redistribution layer (RDL) 2 that can be used to provide or acquire electrical signals to/from the pad, according to the prior art. In particular, the IC 1 is represented in a system of spatial coordinates defined by three axes x, y, z, orthogonal to one another and the cross-section view is taken on an xz plane, defined by the x axis and the z axis. In the following, thicknesses, depths and heights are intended as measured along the z axis, and the meanings of "top" and "bottom", "above" and "below" are defined with reference to the direction of the z axis.

The IC 1 includes an interconnection layer 3, made of conductive material; the redistribution layer 2 includes a dielectric layer 4 extending above the interconnection layer 3 and a first passivation layer 6 extending above the dielectric layer 4. One or more further layers (not shown) may be present between the interconnection layer 3 and the dielectric layer 4 (e.g., in case layer 3 is of Cu, a further SiN layer that protect the Cu metallization may be present between the interconnection layer 3 and the dielectric layer 4) .

The redistribution layer 2 further comprises a barrier region 8, extending above a top surface of the first passivation layer 6 and across the whole depth of the first passivation layer 6 and of the dielectric layer 4, so as to be in contact with the interconnection layer 3.

The redistribution layer 2 further comprises a conductive region 10, extending on top of the barrier region 8. In particular, in a top view of the IC 1, the conductive region 10 extends within the area defined by the barrier region 8.

The barrier region 8 and the conductive region 10 form a conductive path from the interconnection layer 3 to the top surface of the first passivation layer 6.

The redistribution layer 2 further comprises a coating region 12, extending above the first passivation layer 6, around the conductive region 10 and the barrier region 8, and above the conductive region 10. The coating region 12 is in contact with the top surface of the first passivation layer 6, the conductive region 10 and the barrier region 8. Far from the pad, the coating region 12 fully covers the conductive region 10.

In other words, the coating region 12 completely covers the portions of the barrier region 8 and of the conductive region 10 extending above the top surface of the first passivation layer 6.

The redistribution layer 2 further comprises a second passivation layer, or photosensitive insulation layer, 16 (e.g. polyimide, PBO, Epoxy, etc.), fully covering the coating region 12 far from the pad.

In particular, a convenient choice of conductive materials for the redistribution layer 2 is such that the conductive region 10 is made of copper (Cu), the coating region 12 is made of Silicon Nitride with a thickness of about 0.5-1 µm. Other thicknesses may be chosen, according to the needs.

At the pad location, the conductive region 10 can be electrically contacted by wire bonding or, alternatively, by a conductive pillar (e.g., of copper) grown on the conductive region 10 (e.g., by electroplating) through an opening formed through the second passivation layer 16 and the coating layer 12, as shown in Figure 2A.

With reference to Figure 2A, features common to those of Figure 1 are identified with same reference numerals. Here, the conductive region 10 is covered by the coating layer 12 of Silicon Nitride and by the passivation layer 16. The passivation layer 16 extends laterally to, and partially above, the conductive region 10 and the coating layer 12. In particular, the passivation layer 16 has a top opening 16a aimed at allowing access to the conductive region 10. The conductive region 10 can be electrically and physically accessed through such opening 16a after a step of etching away the portion of the coating layer 12 exposed through the opening 16a.

After removal of such portion of the coating layer 12, the conductive region 10 is electrically accessible to carry out electrical testing, in particular EWS ("Electrical Wafer Sorting") testing, functional testing, or other reliability tests. In order not to damage, or cause corrosion / oxidation of, the exposed part of the conductive region 10, the EWS test should be conducted at low temperatures (usually, ambient temperature or lower). This limits the number and typology of tests that can be carried out. Moreover, notwithstanding all care taken during these steps, the copper surface still undergoes oxidations / corrosion phenomena before, during and/or after EWS tests, which generates a general degradation of the surface of the conductive region 10.

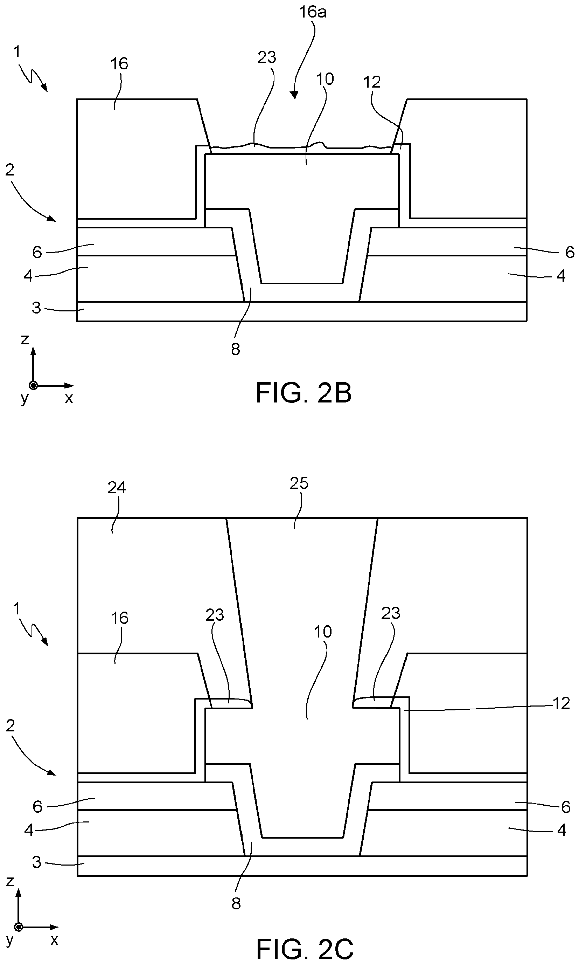

As shown in Figure 2B, an undesired layer 23 (e.g., oxidized or corroded layer) is shown extending not only on the exposed copper surface, but also partially under the coating layer 12 (not shown in the figure).

Figure 2C shows further manufacturing steps to package the IC 1, where a molding layer 24 is deposited within the opening 16a on the conductive region 10 (and at least partially on the undesired layer 23). The molding layer 24 is opened at the conductive region 10 (e.g, through a LASER drilling process) to reach the conductive region 10. The undesired layer 23 and optionally the conductive region 10 are also partially removed through the LASER drilling process, to expose the underlying copper surface on which an electroplating copper growth process can be carried out, to grow the thick copper pillar 25 that provides electrical access to the redistribution layer 2.

During the manufacturing, the steps between the front-end process (Figure 2A) and the back-end process (Figure 2C) involve several corrosion issues of the Cu material, which is not passivated. Such corrosion phenomena may also negatively evolve later during the working life of the device.

As shown in Figure 2C, the not-removed portions of the molding layer 24 are coupled at least in part on a residual portion of the undesired layer 23. The presence of the undesired layer 23 under the protection layer 12 and /or under the molding layer 24 may cause an irreversible detachment of the protection layer 12 / molding layer 24 from the conductive region 10 during further manufacturing steps or, more dangerously, during the working life of the device thus manufactured. In fact, layer 23 is not of a stable material and can be prone to environmental contamination, such as Cl, SO₄ or Fluorine compounds, able to generate further corrosion of the RDL metallization.

Patent document US 2013/228929 relates generally to conductive pads, and more particularly to protection layers for conductive pads and methods of formation thereof. Here, one protection layer is made of metal, and a dedicated thermal treatment, changing the Cu interconnection properties, is also performed. An alloy is therefore formed by the metal protection layer with the covered metal pad.

Patent document US 2015/041985 relates in general to semiconductor devices and, more particularly, to a semiconductor device and method of manufacturing a wafer level chip scale package (WLCSP). This document refers to the BE (Back-End) phase of the manufacturing process, when device is already finished and tested. The EWS testing phase of device is carried out before the deposition of a dielectric protecting layer, where metal contact pad are completely uncovered, limiting the testing phase to low temperatures in order to not damage the metal contact pad.

Therefore, the above patent documents cannot solve at least the above stated issue that, during the manufacturing, the steps between the front-end process (Figure 2A) and the back-end process (Figure 2C) involve several corrosion issues of the Cu material, which is not passivated. Moreover, EWS tests cannot be carried out at high temperatures, due to the already discussed problems.

The aim of the present invention is to provide a method of manufacturing a redistribution layer, a redistribution layer, an integrated circuit including the redistribution layer, a method for performing an electrical test of the integrated circuit, and a method of manufacturing an encapsulation structure for an integrated circuit, to overcome the problems previously illustrated.

According to the present invention, a method of manufacturing a redistribution layer, a redistribution layer, an integrated circuit including the redistribution layer, a method for performing an electrical test of the integrated circuit, and a method of manufacturing an encapsulation structure for an integrated circuit are provided, as defined in the annexed claims.

For a better understanding of the present invention, preferred embodiments thereof are now described, purely by way of non-limiting example and with reference to the attached drawings, wherein:
- Figure 1 is a cross-section view of a portion of an integrated circuit including a redistribution layer, according to the known art;
- Figures 2A-2C show manufacturing steps of the redistribution layer of Figure 1, according to the known art;
- Figure 3 is a cross-section view of a portion of an integrated circuit including a redistribution layer, according to an embodiment of the present invention;
- Figures 4A-4M are cross-section views of steps for manufacturing the redistribution layer of Figure 3;
- Figures 5 and 6 are cross-section views of a respective portion of an integrated circuit including a redistribution layer, according to respective further embodiments of the present invention.

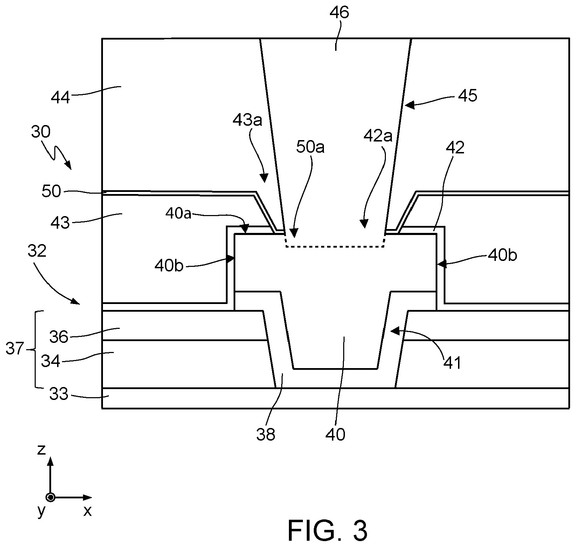

Figure 3 shows an integrated circuit, IC, 30 (only a portion of which is shown in the drawings), represented in a system of spatial coordinates defined by three axes x, y, z, orthogonal to one another and the cross-section view is taken on an xz plane, defined by the x axis and the z axis (analogously to Figure 1 and Figures 2A-2C). In the following, thicknesses, depths and heights are intended as measured along the z axis, and the meanings of "top" and "bottom", "above" and "below" are defined with reference to the direction of the z axis (i.e., such terms refer to respective views on the xy plane or a plane parallel to the xy plane).

Figure 3 shows schematically a cross-section view of a portion of the IC 30 comprising a redistribution layer 32.

The IC 30 further comprises an interconnection layer 33, made of conductive material such as aluminium or copper. In particular, the interconnection layer 33 may be the last metal line of the BEOL of IC 30.

The redistribution layer 32 may include a dielectric layer 34 extending above the interconnection layer 33 and a passivation layer 36 extending above the dielectric layer 34. One or more further layers (not shown) may be present between the interconnection layer 33 and the dielectric layer 34 (e.g., in case layer 33 is of Cu, a further SiN layer that protect the Cu metallization may be present between the interconnection layer 33 and the dielectric layer 34). In particular, the dielectric layer 34 is made of an insulating material, such as silicon dioxide (SiO₂) or a multi stack dielectric made by SiN and SiO₂; the passivation layer 36 is made of an insulating material, such as silicon nitride (Si₃N₄).

The dielectric layer 34 and the passivation layer 36 may be replaced by one single layer of insulating or dielectric material. Therefore, in the following, the term "insulating layer 37" refers either to the stack composed of the dielectric layer 34 and the passivation layer 36, or to a stack formed by more than two layers (e.g., three layers), or otherwise a single layer.

The redistribution layer 32 further comprises a barrier region 38 of conductive material. The barrier region 38 extends across the whole thickness of the insulating layer 37, so as to be in contact with the interconnection layer 33.

The redistribution layer 32 further comprises a conductive region 40, extending on top of the barrier region 38, and having a top surface 40a and lateral walls (or sidewalls) 40b. In particular, in a top view of the IC 30, not shown in the figures, the conductive region 40 is extending only inside the area defined by the barrier region 38. In the following, the term "conductive body" refers to a stack 41 including the barrier region 38 and the conductive region 40. It is noted that, according to a further embodiment, the barrier region 38 may be omitted; accordingly, in such embodiment, the term "conductive body" refers to the conductive region 40 only.

The conductive body 41 forms a conductive path from the interconnection layer 33 to the top surface of the insulating layer 37.

In one embodiment, the barrier region 38 is made of conductive material, such as titanium (Ti), or titanium-tungsten (TiW), or titanium nitride (TiN), and has thickness comprised for instance between 270 nm and 330 nm. In one embodiment, the conductive region 40 is made of conductive material, in particular metal such as copper (Cu), and has thickness comprised for instance between 8 µm and 12 µm.

The redistribution layer 32 further comprises a coating layer 42 that partially covers the conductive region 40; in particular, the coating layer 42 extends around the conductive region 40 completely covering the lateral walls 40b of the conductive region 40 and partially above the conductive region 40, leaving an opening 42a at the top surface of the conductive region 40, through which the surface 40a of the conductive region 40 is exposed during intermediate manufacturing steps (as better detailed later).

According to an aspect of the present invention, the coating layer 42 is of a dielectric or insulating material, in particular Silicon Nitride, for example with a thickness of about 0.5-1 µm. Other thicknesses may be chosen, according to the needs.

A further insulating layer 43, such as a photosensitive insulating layer, extends above the insulating layer 37 and above the coating layer 42. The opening 42a is completely contained (in top-plan view, on the xy plane) within the opening 43a (in one embodiment, they have the same dimension). Materials of such further insulating layer 43 include polyimide, PBO, Epoxy, photosensitive organic material, etc.

A protection layer 50, of a material that provides a protection of the conductive region 40 against oxidation and /or corrosion phenomena, extends on the insulating layer 43 and partially on the conductive region 40 where the conductive region 40 is not covered by the coating layer 42 (due to manufacturing steps, as better explained later).

The protection layer 50 has an opening 50a that coincides (in top-plan view, on the xy plane) with the opening 42a; the opening 50a is therefore completely contained (in top-plan view, on the xy plane) within the opening 43a of the insulating layer 43.

The protection layer 50 has a thickness in the nanometers range (i.e., lower than 100 nm). For instance, the thickness of the protection layer 50 is uniform and is between 1 nm and 100 nm, more in particular between 5 nm and 50 nm.

According to the present invention, protection layer 50 is of an insulating or dielectric material, in particular including Aluminium or Hafnium, or is of an alloy or composite material including Aluminium and/or Hafnium. Exemplary materials are Al₂O₃, HfO₂, HfᵢAlⱼOₖ (where i, j and k are freely selectable), AlN, AlᵢNⱼOₖ (where i, j and k are freely selectable), HfNᵢ (where i is freely selectable). The protection layer 50 may also be a stack formed by a plurality of layers including Aluminum and /or Hafnium and/or their alloys or composites, such as a stack including two or more among HfO₂/Al₂O₃/AlN/HfNᵢ.

Other materials or alloys are possible, provided that they can act as protecting layers against corrosion or degradation or oxidation phenomena of the conductive region 40, and can be deposited with a thickness within the above-identified range.

The protection layer 50 has the following characteristics: good conformity, good continuity, good chemical resistance, good mechanical-electrical properties, and it is not electrically conductive (i.e., it has dielectric or insulating properties). In particular, the conformity and the continuity directly derive from the choice, better discussed later, of depositing this layer by atomic layer deposition (ALD); the chemical resistance, electrical properties and the mechanical-electrical properties are a consequence of the material chosen (as discussed above).

A molding layer 44 extends above the insulating layer 43, and the protection layer 50. The molding layer 44 has a passing hole 45 aligned with the openings 42a, 43a and 50a, and has (in top plan view) the same dimensions as the opening 50a. In intermediate steps of manufacturing, the conductive region 40 is exposed through the opening 50a and the passing hole 45 (as better detailed later).

A thick copper layer 46 (pillar) extends within the passing hole 45 and the opening 50a, reaching the top surface 40a of the conductive region 40 and thus providing electrical access to the conductive region 40 and to the interconnection layer 33 from the environment external to the redistribution layer 42.

As an alternative to the thick copper layer 46, wire bonding can also be used to provide electrical contact to/from the conductive region 40.

It is noted that the molding layer 44 is physically coupled to (lies on) the protection layer 50. The Applicant found that the molding layer 44 can adhere to the protection layer 50 without intermediate undesired layers or regions, and delamination or detachments issues are not present. It is noted that, in other embodiments of the present invention, not shown in the drawings, further layers or regions may be present at the interface between the protection layer 50and the molding layer 44, with the aim of improving the adherence, or for other manufacturing or electrical requirements. In any case, it is noted that according to all the embodiments of the present invention, a corroded or oxidized layer like the undesired layer 23 in Figure 2B is not present.

EWS ("Electrical Wafer Sorting") testing is normally carried out before the formation of the thick copper layer 46 (and normally before formation of the molding layer 44). In particular, according to an aspect of the present invention, EWS testing is carried out at a manufacturing step when the conductive layer 40 is completely covered with, and therefore protected by, the protection layer 50.

As known, EWS testing is carried out using a contacting probe or tip of hard material, typically metal, that is configured to directly contact a conductive surface. Here, during EWS testing, the contacting probe/tip contacts the conductive layer 40. The presence of the protection layer 50 does not significantly impact the execution of EWS tests, since it is thin enough for the contacting probe/tip to "break" it or, more specifically, to pass through it without difficulties. Therefore, during EWS testing, the contacting probe/tip is directed on the protection layer 50 at the conductive layer 40 and pressed on the protection layer 50 until the contacting probe/tip penetrates through the protection layer 50 and reaches (electrically contacts) the conductive layer 40, establishing the required electrical connection for carrying out the tests. The rest of the surface of the conductive layer 40 is, during testing, protected against corrosion or oxidations phenomena that may happen during testing. High temperature testing (up and above 150°C, for example up to 200-300°C) can be carried out without damaging or causing the formation of undesired layers on the conductive layer 40. Other reliability tests, other the EWS testing or further to EWS testing, may also be carried out at high temperatures (up to 300°C).

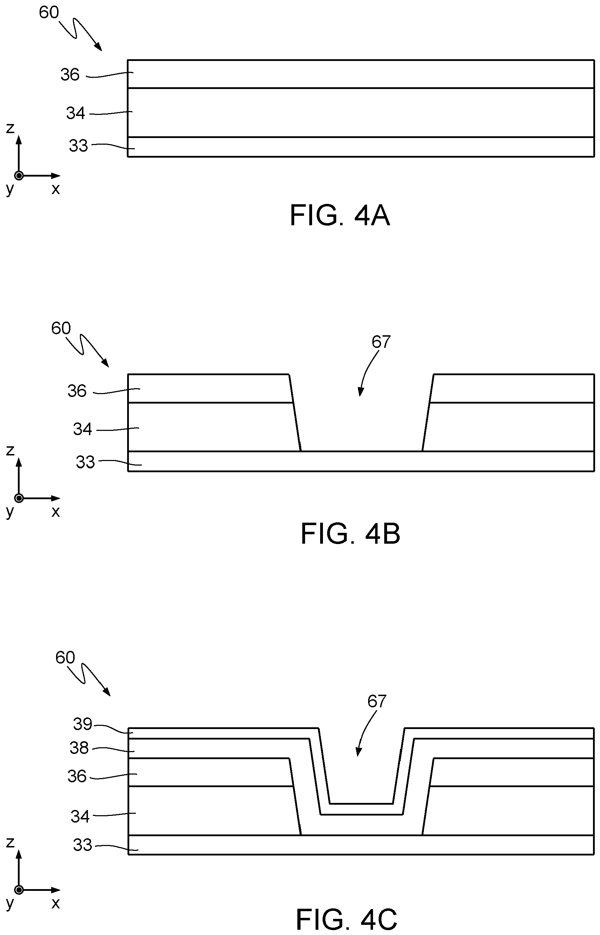

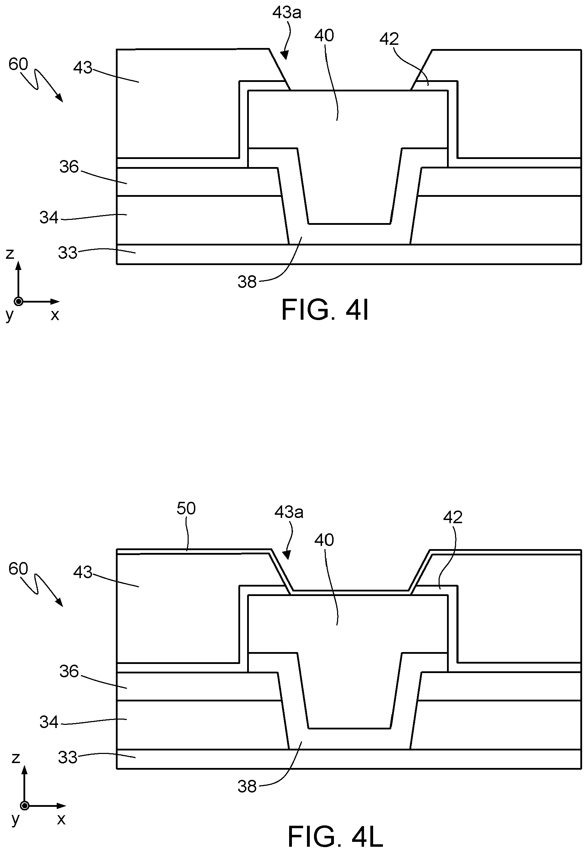

Figures 4A-4M show schematically a cross-section view of steps of a method of manufacturing a redistribution layer according to an embodiment of the present invention; in particular, the method of figures 4A-4M is a method of manufacturing the redistribution layer of Figure 3. The redistribution layer is represented in the system of spatial coordinates defined by three axes x, y, z, orthogonal to one another and the cross-section view is taken on an xz plane, defined by the x axis and the z axis.

With reference to figure 4A, there is provided a wafer 60, including the interconnection layer 33. In particular, the interconnection layer 33 is the outermost metallization layer of the back end of line of an integrated circuit. The lower layers of the integrated circuit are not shown in figures 4A-4M.

The dielectric layer 34 is formed above the interconnection layer 33. In particular, the dielectric layer 34 is made of an insulating material, such as silicon dioxide (SiO₂), and has thickness comprised for instance between 900 nm and 1200 nm.

The passivation layer 36 is formed above the dielectric layer 34. In particular, the passivation layer 36 is made of an insulating material, such as silicon nitride (Si₃N₄), and has thickness comprised for instance between 500 nm and 650 nm. In the following, the term "insulating layer" refers, as already said, to the stack 37 formed by the dielectric layer 34 and the first passivation layer 36, or to a stack formed by more than two dielectric/insulating layers, or even to a single layer of insulating or dielectric or passivation material.

Then, figure 4B, a trench, or via, 67 is formed through the passivation layer 36 and the dielectric layer 34, up to exposing a surface of the interconnection layer 33. For instance, the via 67 is formed by photolithography and dry etching steps of a known type, applied at the exposed surface of the first passivation layer 36.

Then, figure 4C, the barrier layer 38 is formed above the first passivation layer 36, for instance by physical vapor deposition (PVD). The barrier layer 38 partially fills the via 67, covering the previously exposed sidewalls of the dielectric layer 34 and the first passivation layer 36 and the previously exposed surface of the interconnection layer 33.

In particular, the barrier layer 38 is made of conductive material, such as titanium (Ti), or titanium-tungsten (TiW), or titanium nitride (TiN). Moreover, the thickness of the barrier layer 38 may be lower than the combined thickness of the dielectric layer 34 and the first passivation layer 36, and in particular is comprised for instance between 270 nm and 330 nm. Then, a seed layer 39 is formed above the barrier layer 38, partially filling the via 67. For instance, the seed layer 39 is deposited by PVD.

In particular, the seed layer 39 is made of conductive material, such as copper (Cu), and has thickness comprised for instance between 180 nm and 220 nm, such that the via 67 is only partially filled by the seed layer 39.

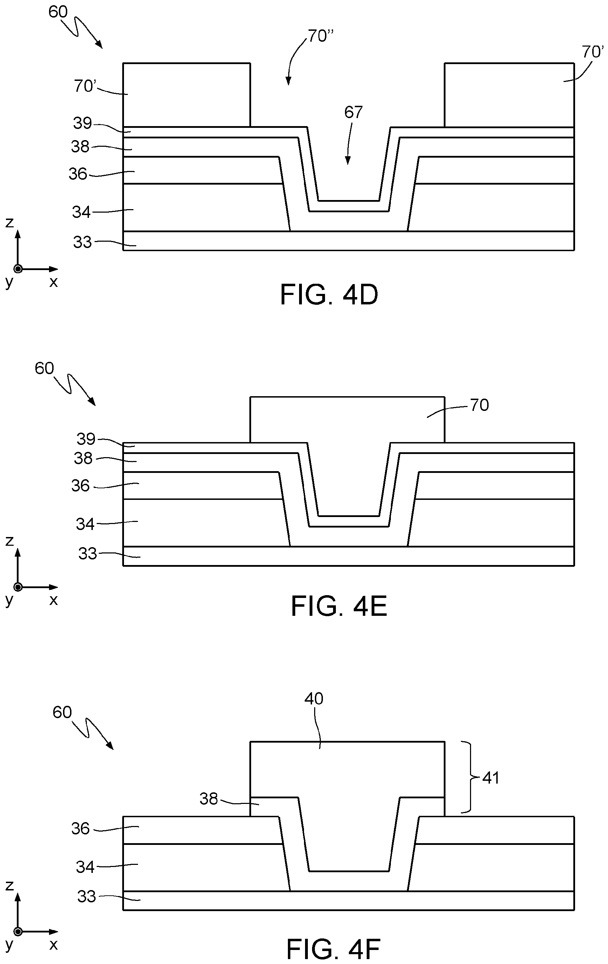

Then, figure 4D, a photolithography mask 70' is applied at the exposed surface of the seed layer 39. In particular, the layout of the photolithography mask 70' is designed considering that openings in the mask define areas in which a layer will be formed in a following step of the manufacturing method.

In particular, figure 4D shows an opening 70" of the photolithography mask 70', the opening 70" being opened on the partially filled via 67 so that the via 67, as well as a region around the via 67, are not covered by the photolithography mask 70'.

Then, figure 4E, a conductive layer 70 is formed above the portions of the seed layer 39 not covered by the photolithography mask 70'. The thickness of the conductive layer 70 is high enough to completely fill the via 67 and partially fill the opening 70" of the photolithography mask 70' .

In particular, the conductive layer 70 is made of the same conductive material of the seed layer 39, such as copper (Cu), and has thickness comprised for instance between 8 µm and 12 µm.

In particular, the conductive layer 70 is formed by electrodeposition. Then, the photolithography mask 70' is removed by a wet removal process, exposing portions of the seed layer 39 not covered by the conductive layer 70.

Then, figure 4F, said exposed portions of the seed layer 39, not covered by the conductive layer 70, are removed, for instance by wet etching, up to exposing the portions of the barrier layer 38 underneath them. Thus, the remaining portions of the seed layer 39, covered by the conductive layer 70, form, together with the conductive layer 70, the conductive region 40 of the redistribution layer 32 of Figure 3.

Then, the exposed portions of the barrier layer 38 are removed, for instance by wet etching, up to exposing the portions of the first passivation layer 36 underneath, without affecting the portions of the barrier layer 38 below the conductive layer 70, for instance by employing standard photolithography techniques by or directly using layer 40 as a mask for the underlying layer 38. As a consequence, the barrier layer 38 of the redistribution layer 32 of Figure 3 is formed.

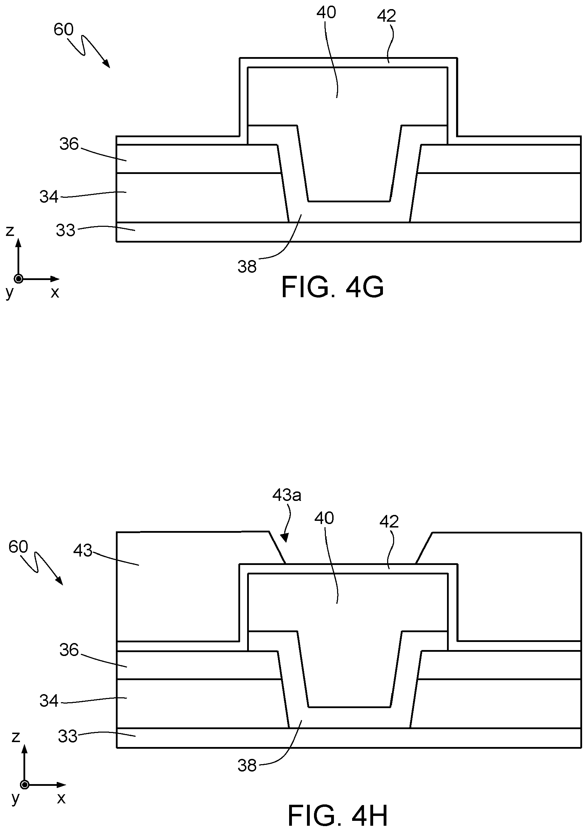

Then, Figure 4G, the coating layer 42 is formed on the exposed surface of the conductive layer 40 and on the barrier layer 38 exposed laterally to the conductive layer 40. The coating layer 42 is formed by depositing SiN, for example by CVD.

The coating layer 42 completely covers the conductive region 40 and the passivation region 36

Then, figure 4H, steps for forming the further insulating layer 43 are carried out. For example, the insulating layer 43 is formed by passivation with an organic photosensitive material deposited by spin coating or lamination (as examples).

The aperture 43a is formed through the insulating layer 43, by patterning the insulating layer 43 through photolithographic techniques, to form an access to the coating layer 42. As said above, the insulating layer 43 is a photosensitive material. Region 43a is formed through photolithographic patterning known per se to the one skilled in the art (e.g., exposure to suitable radiation through a photolithographic mask, followed by chemical development step that removed the photosensitive material where exposed (- or not exposed, depending on resin type, which can be of a positive or negative type).

Then, Figure 41, the coating layer 42 is selectively etched to remove portions of the coating layer 42 exposed through the aperture 43a, until the surface of the conductive layer 40 is exposed.

A native oxide can grow on the exposed surface of the conductive layer 40. A cleaning step can be carried out to remove the native oxide, for example using a chemistry based on HF.

With reference to Figure 4L, the protection layer 50 is formed (deposited) by atomic layer deposition (ALD) of an alloy or compound including Aluminium or Hafnium. In general, the protection layer 50 may be one of: an oxide of Aluminum or Hafnium; a nitride of Aluminum; a compound such as HfₓAl_{y}O_{z}; a multiplayer including a plurality of sub-layers different from one another, each sub-layer being of one among the above-cited materials.

The protection layer 50 completely and uniformly covers the conductive region 40 (where exposed through aperture 43a) as well as the insulating layer 43.

Plasma-assisted ALD or thermal ALD can be used interchangeably to form the protection layer 50.

The process for forming the protection layer 50 includes the following parameters:
Temperature range during deposition, for plasma-assisted ALD: 20-300 °C;
Temperature range during deposition, for thermal ALD: 150 - 500 °C;
Type of precursors used (at least one among): TMA, H₂O, HfCl₄, O₃ + TEMAHf, N₂H₄, NH₃; typically, two precursors are used together, such as H₂O + TMA to obtain Al₂O₃, or HfCl₄ + H₂O to obtain HfO₂;
Pressure range during deposition, for plasma-assisted ALD: equal to or less than 1 Torr;
Pressure range during deposition, for thermal ALD: from 1 mTorr to 20 Torr.

The protection layer 50 thus formed has the following properties:
Density (@ 20 °C) in the range 2 - 11 g/cm³

Refractive index (at 550 nm - 633 nm wavelength) in the range 1.6 - 2.3.

Another process for forming the protection layer 50 (which can be applied in the context of the embodiment of Figure 3) includes carry out a PECVD deposition of a thin layer (i.e., under 100 nm, for example between 10 nm and 100 nm) of a dielectric or insulating material, such as silicon carbon nitride (SiCN).

After the steps of Figure 4L, the EWS test, or any other electrical test, can be carried out, as already described, since the protection layer 50 is directly accessible by the testing probe. As already discussed, the probe penetrates through the protection layer 50 to reach the conductive region 40 to carry out the EWS test without leaving portions of the conductive region 40 exposed to the test environment. More precisely, only a small area of the conductive region (where the protection layer has been broken/opened by the probe tip) is left exposed to the test environment, and this only after the EWS has been carried out. This drastically reduces the risk of potential corrosion issues and their consequences on EWS test reliability and molding material delamination.

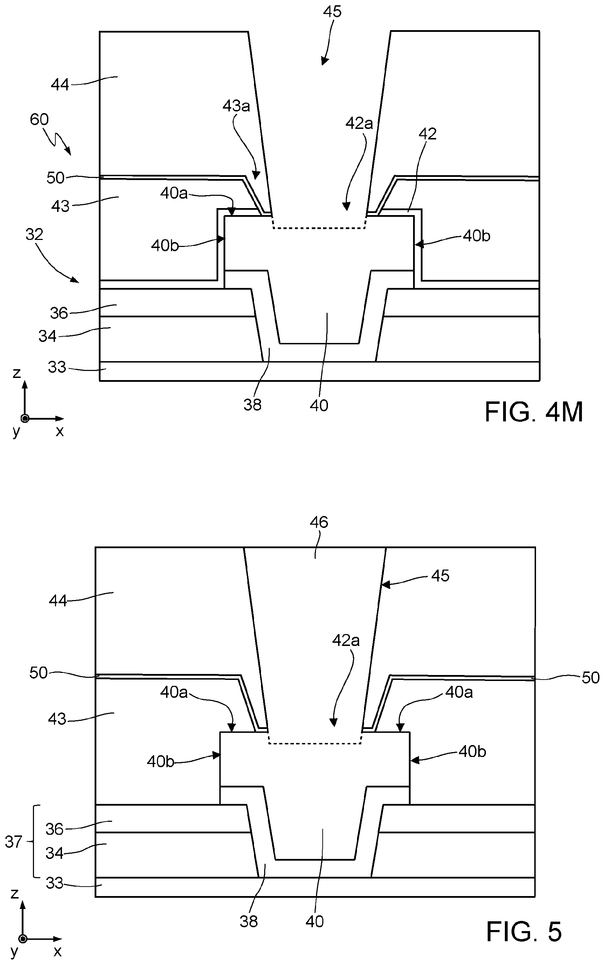

Then, Figure 4M, a packaging process is carried out, using a molding material such as a polymeric material deposited by injection molding, or formed by transfer molding or top gate molding, or other techniques known in the art (thus forming the molding layer 44). The molding layer 44 is formed (e.g., deposited) above the insulating layer 43 and in particular on the protection layer 50. A Laser drilling, or other patterning technique, is then carried out to selectively remove portions of the molding layer 44 and layer 50, to form the opening 45. It is noted that the molding layer 44 is physically coupled to the protection layer 50. Other embodiments are possible, where one or more intermediate layers between the protection layer 50 and the molding layer 44 are present.

The steps for forming the molding layer 44 are carried out during the back-end process.

Selective portions of the molding layer 44 are then removed (for example by a LiSI - "Laser Induced Strip Interconnect" - process step), thereby forming the passing hole 45.

A step of forming a conductive connection region 46, in the form of pillar (analogously to the pillar 25 of Figure 1), is then carried out. If the conductive region 40 is of metal (such as Copper), the conductive connection region 46 can be formed by electroplating metal (Copper) material, filling the apertures 42a, 43a and the passing hole 45 with such metal (Copper). The conductive connection region 46 thus formed is in electrical contact with the conductive region 40 and, through the conductive region 40, with the interconnection layer 33. The integrated circuit 30 of Figure 3 is thus formed.

The described process is one of the possible alternatives to form Copper Direct Interconnect (that is, providing electrical connection between die and package without resorting to wire bonding). Alternatives may foresee the use of materials different from the molding for packaging, and techniques different for LiSI, such as an aEASI process. Moreover, alternatively to the step of forming a conductive connection region 46 in the form of pillar, a wire bonding can be implemented, as apparent to the skilled person in the art. In case of wire bonding, the layer 44 is formed afterwards and partially covers the wire.

Figure 5 shows a further embodiment of a redistribution layer of present invention, where features/elements common to those of Figure 3 are identified using the same reference numerals and not further described.

The redistribution layer of Figure 5 differs from the redistribution layer 32 in that the coating layer 42 is not present. In this case, the insulating layer 43 is formed on the insulating layer 37 and on the conductive layer 40 (on part of the top surface 40a and on the sidewalls 40b).

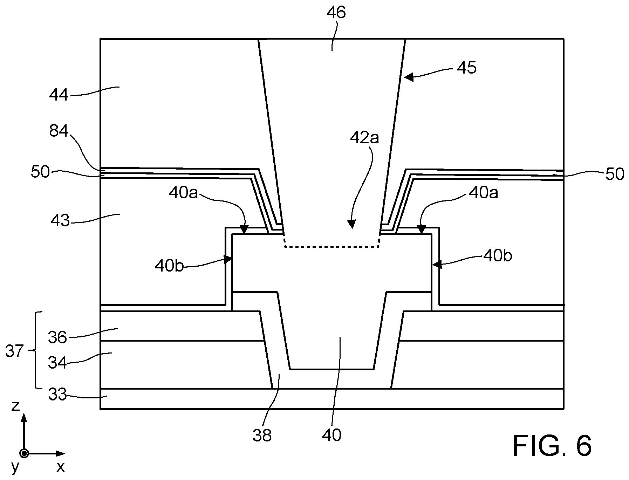

Figure 6 shows a further embodiment of a redistribution layer of present invention, where features/elements common to those of Figure 3 are identified using the same reference numerals and not further described.

The redistribution layer of Figure 6 differs from the redistribution layer 32 in that it further comprises a second protection layer 84 that covers the protection layer 50. The second protection layer 84 extends on the protection layer 50, in direct contact with the protection layer 50. The second protection layer 84 has an opening 84a which matches, in terms of shape and dimension, the opening 50a of the protection layer 50, or that is larger than the opening 50a, so that, in top plan-view, the opening 50a is completely contained within the opening 84a.

The second protection layer 84 is made of a material having a low thermal expansion coefficient in the range 0.5·10⁻⁶ - 6.0·10⁻⁶ 1/K, to provide a further protection to the conductive region 40 during high-temperature EWS testing. In particular, the second protection layer 84 provides a further protection against corrosion / oxidation / degradation of the conductive region 40 in case, during high-temperatures EWS processes, the protection layer 50 locally breaks or cracks.

Exemplary materials that can be used for the second protection layer 84 are insulators or dielectrics, such as Silicon Nitrides (e.g., Si₃N₄), Silicon Carbon Nitrides (SiCN), Silicon Oxides (e.g., SiO₂), Silicon Oxycarbides (SiOC). The second protection layer 84 can also be formed as a stack including one or more of the above-listed materials.

The second protection layer 84 has a thickness in the range 0.01 µm - 1 µm (for example, between 0.1 µm and 1 µm).

In general, the material of the second protection layer 84 is chosen such that it can sustain high temperatures (up to 300°C) during high-temperature testing (such as EWS tests) without damages. In particular, such damages include cracking, fractures, etc., which may cause electromigration phenomena, electrochemical migrations, etc.

The process steps for manufacturing the embodiment of Figure 6 substantially conform with that already described with reference to wafer 60, with the further steps of forming the second protection layer 84 on the protection layer 50.

The advantages of the invention described previously, according to the various embodiments, emerge clearly from the foregoing description.

In particular, the protection layer 50 is considerably thin and can be deposited by ALD with a highly controlled thickness, and good conformity. Is also provides a good diffusion barrier for the underlying Copper region 40 (it acts as a corrosion migration barrier); it further enables EWS testing without the need for a preliminary etching step, thus preserving the thermomechanical stability.

Further advantages include cost saving, due to a simpler manufacturing process than the prior art; improved oxidation protection during taping and reduced delamination in case of BSM (back side metal) needs; no risk of unstable EWS test at high temperatures; no risk of contamination of the photosensitive insulating layer 43 during front-end processes and reduced contamination risk during EWS; no risk of contamination of the conductive layer 40 during front-end (FE) processes and reduced contamination risk during EWS; low risk of corrosion when the device is stored in an uncontrolled environment before during / after EWS and shipment; low risk of corrosion of the conductive layer 40 during back grinding (tape contamination) and around pad opening (during LiSI or, generally, during direct Cu interconnect assembly).

Finally, it is clear that modifications and variations may be made to what has been described and illustrated herein, without thereby departing from the scope of the present invention, as defined in the annexed claims.

For example, insulating layers 37 and 43 may be of a same material, so that at the end of manufacturing they result in a single insulating region or insulating layer.

In particular, even though the advantages and specific application of the present invention has been discussed with explicit reference to EWS testing, the present invention is advantageous, and can be used, to protect the conductive layer 40 from corrosion/oxidation phenomena during all phases of the FE (front-end) and BE (back-end) process flow (and between FE and BE), guaranteeing at the same time the electrical testability without degradation or pad probe instability (in particular during EWS/PT carried out between FE and BE phases).

## Claims

1. A method of manufacturing a redistribution layer (32) for an integrated circuit (30), comprising the steps of:
- forming, on a conductive interconnection layer (33) of a wafer (60), a first insulating layer (37);
- forming a conductive body (40; 40, 38; 41) in electrical contact with said interconnection layer (33);
- covering said conductive body (40; 40, 38; 41) with an insulating region (42, 43) having an aperture (43a) that exposes a surface of the conductive body (40; 40, 38; 41);
- covering said surface of the conductive body (40; 40, 38; 41) and the insulating region (37, 43) with a protection layer (50) of dielectric or insulating material having a thickness lower than 100 nm.

2. The method of claim 1, wherein the protection layer (50) includes Aluminum and / or Hafnium.

3. The method of claim 1 or claim 2, wherein the step of forming the protection layer (50) comprises performing one among: an atomic layer deposition, a thermal atomic layer deposition, a plasma-assisted atomic layer deposition, a CVD, a PECVD.

4. The method of anyone of the preceding claims, further comprising the step of locally perforating with a testing probe or testing tip the protection layer (50) until the conductive body (40) is electrically contacted by said testing probe or testing tip.

5. The method of claim 4, further comprising, after having locally perforated the protection layer (50), the steps of:
forming a molding layer (44) on the protection layer (50);
forming a first passing hole (45) throughout the molding layer (44), until a surface portion of the protection layer (50) is exposed;
forming a second passing hole (50a) throughout the protection layer (50), until a said surface of the conductive body (40) is exposed;
electrically contacting the conductive body (40) through the first and second passing holes (45, 50).

6. The method of claim 5, wherein electrically contacting the conductive body (40) includes one of: forming a conductive pillar (46) within said first and second passing holes (45, 50), in electrical contact with the conductive body (40); or carry out a wire bonding operation on the exposed surface of the conductive body (40).

7. The method of anyone of the preceding claims, further comprising the step of covering the protection layer (50) with a further protection layer (84) configured to sustain temperatures up to 300 °C without damages.

8. The method of claim 7, wherein the further protection layer (84) has a coefficient of thermal expansion in the range 0.5·10⁻⁶ - 6.0·10⁻⁶ 1/K.

9. The method of claim 7 or 8, wherein the further protection layer (84) is of a dielectric or insulating material such as a Silicon Nitride, a Silicon Carbon Nitride, a Silicon Oxycarbide, a Silicon Oxide.

10. The method of anyone of claims 7-9, wherein the further protection layer (84) has a thickness in the range 0.01 µm - 1 µm.

11. The method of anyone of claims 7-10 when depending upon claim 4, further comprising, before the step of locally perforating the protection layer (50), the step of removing selective portions of the further protection layer (84) above the location where said step of locally perforating is to be carried out.

12. The method of anyone of the preceding claims, wherein forming the insulating region (42, 43) includes forming a coating layer (42) of Silicon Nitride that completely covers the conductive body (40).

13. The method of claim 12, wherein forming the insulating region (42, 43) further includes forming a photosensitive insulating layer (43) on the coating layer (42) .

14. The method of anyone of claims 1-11, wherein forming the insulating region includes forming a photosensitive insulating layer (43) that completely covers the conductive body (40).

15. The method of claim 14, wherein said photosensitive insulating layer (43) is of a material among: polyimide, PBO, Epoxy, photosensitive organic material.

16. The method of anyone of the preceding claims, wherein said interconnection layer (33) is the outermost metallization layer of the back end of line of said integrated circuit (30).

17. A redistribution layer (32) for an integrated circuit (30), comprising:
- a conductive interconnection layer (33)
- a conductive body (40; 40, 38) in electrical contract with said interconnection layer (33);
- an insulating region (42, 43) around the conductive body (40; 40, 38) having an aperture (43a) at a surface of the conductive body (40; 40, 38; 41);
- a protection layer (50) extending on said insulating region (42, 43) and partially on said surface of the conductive body (40; 40, 38), being of a dielectric or insulating material and having a thickness lower than 100 nm.

18. The redistribution layer of claim 17, wherein the protection layer (50) includes Aluminum and / or Hafnium.

19. The redistribution layer of claim 17 or 18, further comprising a further protection layer (84) on the protection layer (50), the further protection layer (84) being configured to sustain temperatures up to 300 °C without damages.

20. The redistribution layer of claim 19, wherein the further protection layer (84) has a coefficient of thermal expansion in the range 0.5·10⁻⁶ - 6.0·10⁻⁶ 1/K.

21. The redistribution layer of claim 19 or 20, wherein the further protection layer (84) is of a dielectric or insulating material such as a Silicon Nitride, a Silicon Carbon Nitride, a Silicon Oxycarbide, a Silicon Oxide.

22. The redistribution layer of anyone of claims 19-21, wherein the further protection layer (84) has a thickness in the range 0.01 µm - 1 µm.

23. The redistribution layer of anyone of claims 17-22, wherein the insulating region (42, 43) includes a coating layer (42) of Silicon Nitride that completely covers the conductive body (40).

24. The redistribution layer of claim 23, wherein the insulating region (42, 43) further includes a photosensitive insulating layer (43) on the coating layer (42).

25. The redistribution layer of anyone of claims 17-24, wherein the insulating region includes a photosensitive insulating layer (43) that completely covers the conductive body (40).

26. The redistribution layer of anyone of claims 23-25, wherein said photosensitive insulating layer (43) is of a material among: polyimide, PBO, Epoxy, photosensitive organic material.

27. The redistribution layer of anyone of the claims 17-26, wherein said interconnection layer (33) is the outermost metallization layer of the back end of line of said integrated circuit (30).

28. The redistribution layer of anyone of claims 17-27, further comprising a molding layer (44) on the protection layer (50) having a first passing hole (45) that reaches a surface portion of the protection layer (50),
wherein the protection layer (50) has a second passing hole (50a) that reaches said surface of the conductive body (40),
the redistribution layer (32) further comprising an electrical contact element that electrically contact the conductive body (40) through the first and second passing holes (45, 50).

29. The redistribution layer of claim 28, wherein the electrical contact element includes one of: a conductive pillar (46) within said first and second passing holes (45, 50a), in electrical contact with the conductive body (40); or a wire, which is bonded to the exposed surface of the conductive body (40).

30. An integrated circuit (30) having a redistribution layer (32) according to anyone of claims 17-29.

31. A method of performing an electrical test of an integrated circuit including a redistribution layer according to anyone of claims 17-26, comprising the step of locally perforating with a testing probe or testing tip the protection layer (50) until the conductive body (40) is electrically contacted by said testing probe or testing tip, for carrying out said electrical test.

32. A method of manufacturing an encapsulation structure, comprising the steps of:
providing an integrated circuit according to claim 30;
forming a molding layer (44) on the protection layer (50);
forming a first passing hole (45) throughout the molding layer (44), until a surface portion of the protection layer (50) is exposed;
forming a second passing hole (50a) throughout the protection layer (50), until said surface of the conductive body (40) is exposed;
electrically contacting the conductive body (40) through the first and second passing holes (45, 50).

33. The method of claim 32, wherein electrically contacting the conductive body (40) includes one of: forming a conductive pillar (46) within said first and second passing holes (45, 50), in electrical contact with the conductive body (40); or carry out a wire bonding operation on the exposed surface of the conductive body (40).
